# FASCICULE DE BREVET EUROPEEN

(11) **EP 0 703 473 B1**
(45) Date de publication et mention de la délivrance du brevet: **09.04.2003**
(21) Numéro de dépôt: 95402130.9
(22) Date de dépôt: 21.09.1995
(51) Int. Cl.: G02B 6/12, G02B 6/34, H01S 5/02

(54) **Dispositif optoélectronique intégré pour la séparation de longueurs d'onde différentes et leur détection**
Integriert-optoelektronische Vorrichtung zur Aufspaltung und Erkennung von verschiedenen Wellenlängen
Integrated optoelectronic device for the separating and detecting of different wavelengths

(30) Priorité: 23.09.1994 FR 9411369
(43) Date de publication de la demande: 27.03.1996
(73) Titulaire: ALCATEL, 75382 Paris Cédex 08 (FR)
(72) Inventeur: Bruno, Adrien, F-91120 Palaiseau (FR)
(74) Mandataire: Lamoureux, Bernard

(56) Documents cités:
- EP-A- 0 422 854
- EP-A- 0 561 672
- ELECTRONICS LETTERS., vol. 29, no. 4, 18 Février 1993 STEVENAGE GB, pages 326-328, TH. SCHWANDER ET AL. 'SIMPLE AND LOW-LOSS FIBRE-TO-CHIP COUPLING BY INTEGRATED FIELD-MATCHING WAVEGUIDE IN InP'
- ECOC '93, Montreux, Suisse, sept. 12-16 1993, volume 3, M.R. Amersfoort et al.: 'High Performance PHASAR Wavelength Demultiplexer Integrated with Photodetecto
- IEEE PHOTONICS TECHNOLOGY LETTERS, vol. 6, no. 4, Avril 1994 NEW YORK US, pages 516-518, M. ZIRNGIBL ET AL. 'Digitally Tunable Laser Based on the Integration of a Waveguide Grating Multiplexer and an Optical Amplifier'
- Proceedings ECOC-IOOC'91, Paris, septembre 1991, Vol.1, MoB2-5. pages 69-72

## Description

La présente invention concerne le domaine technique de l'optoélectronique, c'est-à-dire le domaine des dispositifs semiconducteurs qui réunissent des circuits optiques à des circuits électroniques sur le même matériau.

La présente invention peut trouver notamment application dans le domaine des télécommunications et des capteurs en télémétrie. Le dispositif conforme à l'invention peut être utilisé comme un récepteur optique d'un circuit de réception en détection directe, par exemple pour des systèmes de liaison optique. Ce dispositif permet de séparer des signaux de longueurs d'onde différentes, par exemple des signaux de longueurs d'onde différentes arrivant d'une même fibre, vers différents utilisateurs, chacun recevant sa propre longueur d'onde. Le dispositif conforme à l'invention pourra être utilisé également dans les interconnexions optiques entre, par exemple des "puces" électroniques rapides à haut degré d'intégration ou entre ordinateurs, ou encore à l'intérieur d'ordinateurs.

De nombreux sous-ensembles pour dispositifs optoélectroniques ont déjà été proposés.

Il a été proposé par exemple des Amplificateurs Optiques (AO) ayant pour fonction d'amplifier optiquement un signal reçu. Une structure d'amplificateur-détecteur optique est décrite notamment dans le document R. Dall'ara et al., European Conference on Optical Communication, p393, 1994, "Polarization Insensitive Multifunctional Monolithically Integrated Optical Amplifier/Photodetector". Ce document décrit un amplificateur-récepteur optique obtenu par une gravure d'un ruban dans une structure semiconductrice.

Il a été proposé également plusieurs filtres multilongueur d'onde. Plus précisément, on a proposé deux types de structures permettant la séparation spatiale en longueur d'onde d'un même faisceau d'entrée : le spectographe à réseau vertical (SRV) et le spectographe à réseau de guides d'onde (SRG).

Le premier utilise un réseau gravé classique mais vertical. Le second utilise deux dioptres plans séparés par un faisceau de guides de longueurs différentes, à pas constant. Le déphasage induit par la différence de longueur sépare en longueur d'onde en sortie du second dioptre.

Une structure du type SRV est décrite dans le document C. Cremer et al. (Siemens) "Grating spectrograph in InGaAsP/InP for dense wavelegnth division multiplexing", APL 59(6), 5/8/91, p627.

Des structures du type SRG sont décrites dans les documents 1) B.H. Verbeek et al. "Large Bandwidth Polarization Independant and Compact/8 Channel PHASAR Demultiplexer/Filter", OFC94, PD 13-1 et 2) M. Zirngibl et al. (AT&T) "Polarisation independent 8x8 waveguide grating multiplexer on InP", Elec.Lett.21/01/93, vol. 29, n°2, p201.

Le dispositif décrit dans le document Verbeek possède huit entrées et huit sorties. Il est indépendant de la polarisation (TE, TM) grâce à une très faible biréfringence. Sa taille est de 2,6x2,3mm². Il est réalisé avec plusieurs rayons de courbure.

Dans le document Zirngibl, l'indépendance à la polarisation est obtenue en utilisant des ordres différents entre les modes TE et TM puisque la faible biréfringence existant pour ce type de guide n'est pas suffisante pour avoir l'indépendance à la polarisation en travaillant avec le même ordre en TE et TM.

Le document M.R.Amersfoort et al. (Delft University) "High Performance 4-channel PHASAR Wavelength Demultiplexer Integrated with Photodetectors", ECOC 93, p49 a ébauché une intégration de filtre et photodétecteur. La taille du dispositif obtenue est de 3x2,3mm². Les diodes ont des dimensions de 150x80µm².

Le document Electronics Letters, Volume 29, n° 4, février 1993, pages 326-328, décrit un dispositif optoélectronique qui regroupe sur un substrat un adaptateur de mode, un filtre apte à séparer différentes longueurs d'onde d'un signal, un photodétecteur et un guide assurant la liaison entre les éléments précités.

Le document EP-A-0561672 décrit un amplificateur optique intégré et laser mettant en oeuvre un tel amplificateur qui comprend, sur un substrat isolant, un amplificateur optique bordé à chacune de ces extrémités par un adaptateur de mode, suivi d'un guide optique.

La présente invention a maintenant pour but de perfectionner les dispositifs optoélectroniques existants.

Le but de la présente invention est notamment de permettre, au niveau de la réception, le démultiplexage en longueur d'onde par l'utilisation d'un dispositif optoélectronique intégré sur un substrat semi-isolant.

Plus précisément, la présente invention a pour but d'optimiser les paramètres suivants dans un récepteur en détection directe : la taille, les pertes d'insertion, les pertes internes, l'indépendance à la polarisation, la rapidité du photodétecteur, la séparation entre canaux et le nombre de canaux.

Ces buts sont atteints, selon la présente invention, grâce à un dispositif optoélectronique du type defini en revendication 1 annexée.

Selon une autre caractéristique avantageuse de la présente invention, l'adaptateur de mode est formé par gravure en forme de sablier.

Selon une autre caractéristique avantageuse de la présente invention, il est prévu au moins un amplificateur optique après le filtre séparateur de longueur d'onde, associé un photodétecteur spécifique.

L'invention qui permet l'intégration des différents éléments constituant le dispositif optoélectronique (adaptateur de mode, amplificateur optique, filtre séparateur de longueur d'onde et photodétecteur) ainsi que les guides optiques, permettant leur liaison, en réalisant ces éléments et le guide dans le même matériau, va à l'encontre des enseignements de l'état de la technique.

Sur ce point, l'ébauche d'intégration d'un filtre et de photodétecteurs proposés dans le document Amersfoort est notable. En effet, pour permettre des longueurs d'absorption faible (150µm), ce document préconise l'utilisation d'un guide à petit mode (couche guide = 0.6µm).

Pour l'intégration d'un amplificateur optique le raisonnement est le même que celui effectué par Amersfoort pour le détecteur : il faut qu'il y ait un recouvrement important du mode guidé avec la couche amplificatrice ou photodétectrice. Ce recouvrement est moins important avec des guides à mode large, d'où la tendance, selon l'état de la technique, à intégrer des filtres séparateurs à faible mode.

D'autres caractéristiques, buts et avantages de la présente invention apparaîtront à la lecture de la description détaillée qui va suivre, et en regard des dessins annexés donnés à titre d'exemples non limitatifs et sur lesquels :
- la figure 1 représente le schéma de principe d'un sytème optoélectronique de détection directe conforme à la présente invention,
- la figure 2 représente une vue de dessus d'une structure intégrée avec trois miroirs sur chaque trajet optique, au niveau du filtre séparateur,
- la figure 3 représente la structure intégrée de la figure 2, en coupe,
- la figure 4 représente une variante de réalisation, en vue de dessus, d'une structure intégrée avec quatre miroirs sur chaque trajet optique au niveau du filtre séparateur, conforme à la présente invention,
- la figure 5 représente plus en détail, une vue de dessus de l'intégration d'un guide optique à mode large et d'un amplificateur optique conforme à la présente invention,
- les figures 6, 7, 8 et 9 représentent des vues en coupe transversale de ce même ensemble selon des plans de coupe référencés respectivement VI, VII, VIII et IX sur la figure 5, et correspondant respectivement à une zone de décroissance d'un adaptateur de mode, à l'amplificateur optique, à la gorge d'un adaptateur de mode en forme de sablier et à la zone de croissance d'un adaptateur de mode en sablier,
- la figure 10 représente une vue similaire de dessus illustrant l'intégration d'un guide mode large et d'un photodétecteur conforme à la présente invention,
- les figures 11, 12 et 13 représentent des vues en coupe transversale du même ensemble selon des plans de coupe référencés XI, XII et XIII sur la figure 10, et correspondent respectivement à une zone d'entrée d'un adaptateur de mode, à une zone de croissance d'un adaptateur de mode et au photodétecteur,
- les figures 14, 15 et 16 représentent des vues en perspective schématique, respectivement de l'ensemble intégrant un guide mode large et un amplificateur optique conforme à la figure 5, de l'ensemble constituant un filtre séparateur de longueur d'onde à miroir et de l'ensemble conforme à la figure 10 intégrant un guide mode large et un photodétecteur,
- la figure 17 représente une vue de dessus d'une variante, conforme à la présente invention, de structure intégrée à miroirs comprenant un amplificateur optique placé entre le filtre séparateur de longueur d'onde formant multiplexeur et chaque photodétecteur,
- la figure 18 représente une vue en coupe du même dispositif,
- la figure 19 représente une vue de dessus partielle du dispositif conforme à la présente invention représentée sur la figure 17 et illustre plus précisément l'intégration d'un guide mode large et d'un amplificateur optique associé à un photodétecteur,
- les figures 20 et 21 représentent des vues en coupe transversale du même ensemble selon des plans de coupe référencés XX et XXI sur la figure 19.

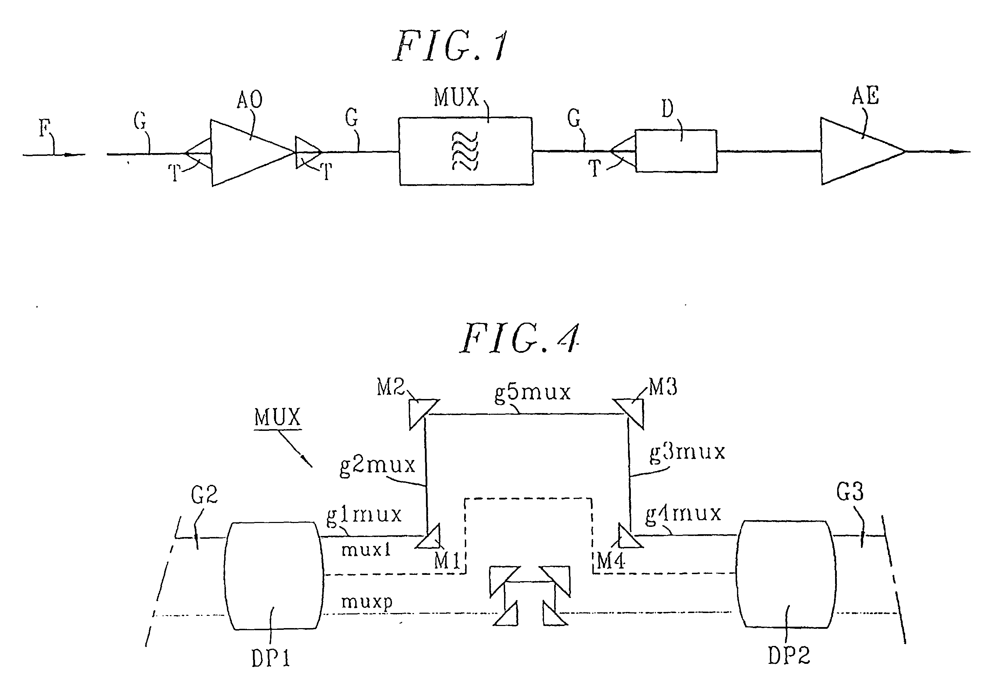

On a représenté sur la figure 1 annexée, la structure générale d'un dispositif optoélectronique intégré conforme à la présente invention comprenant un amplificateur optique AO, un filtre séparateur de longueur d'onde MUX, et au moins un photodétecteur D.

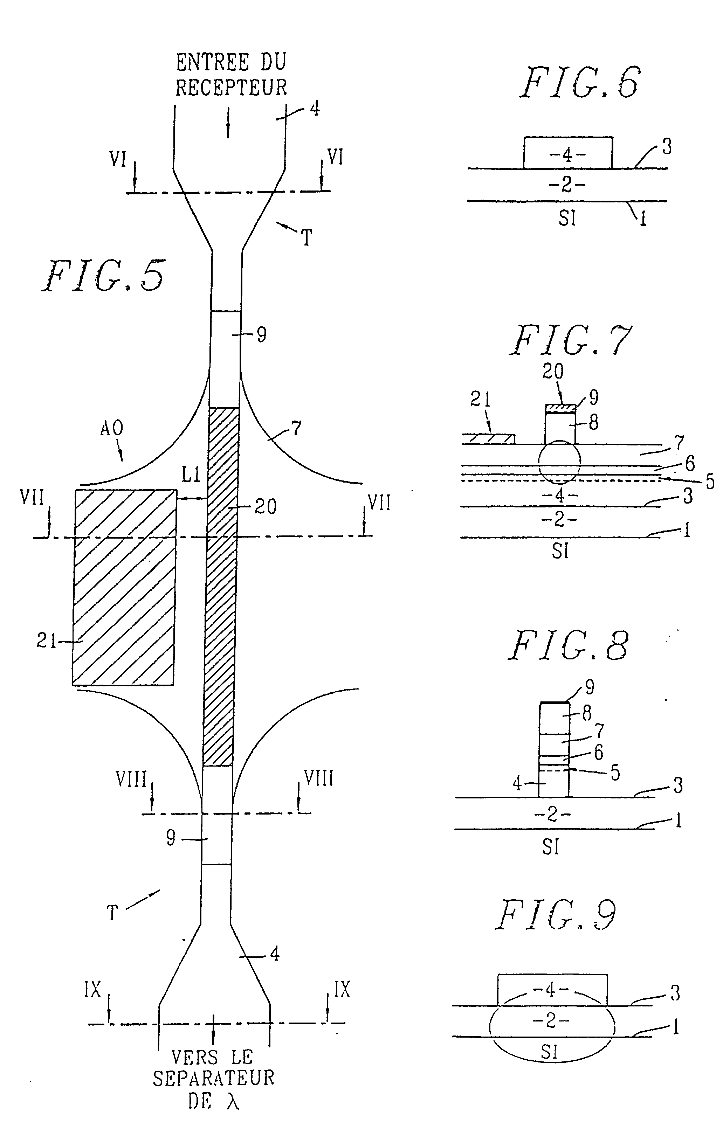

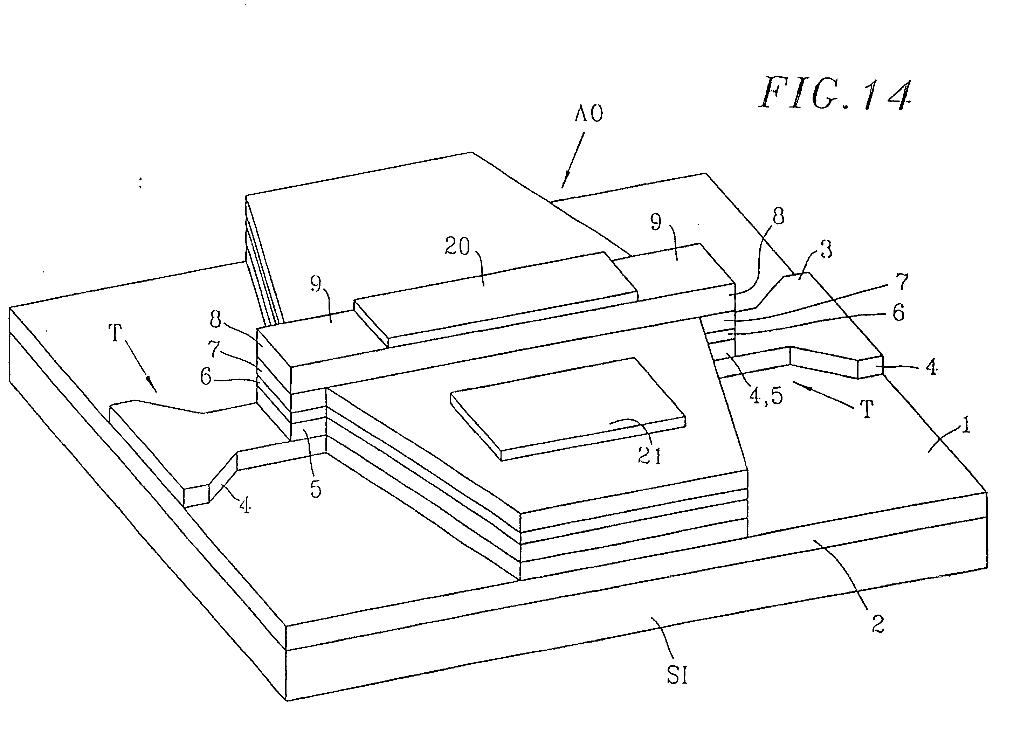

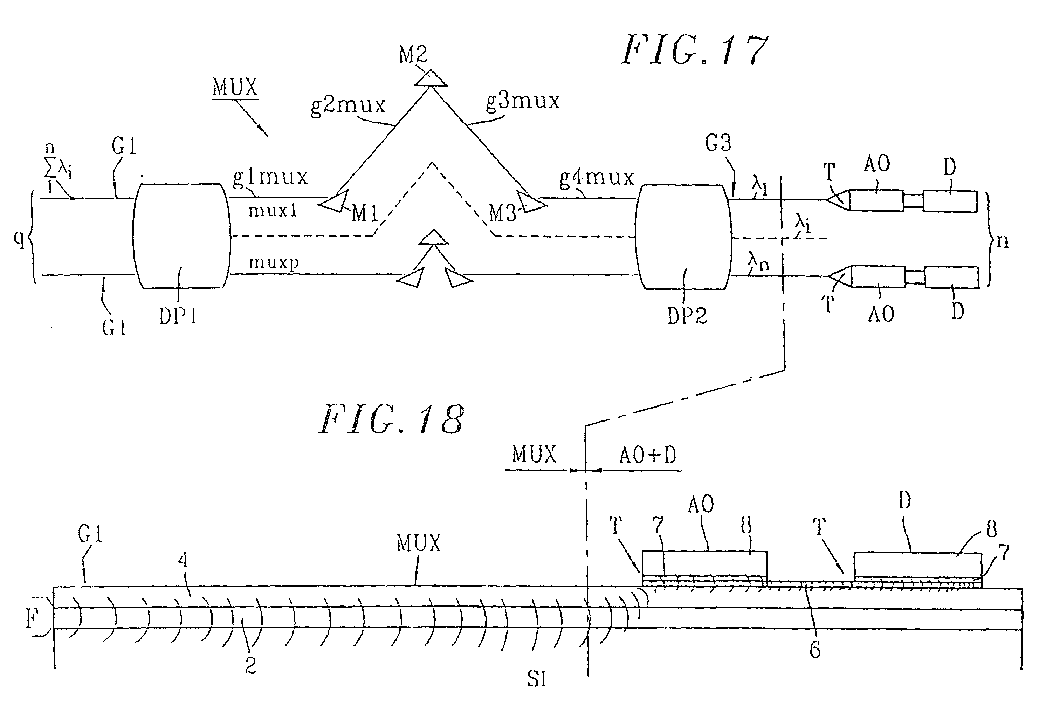

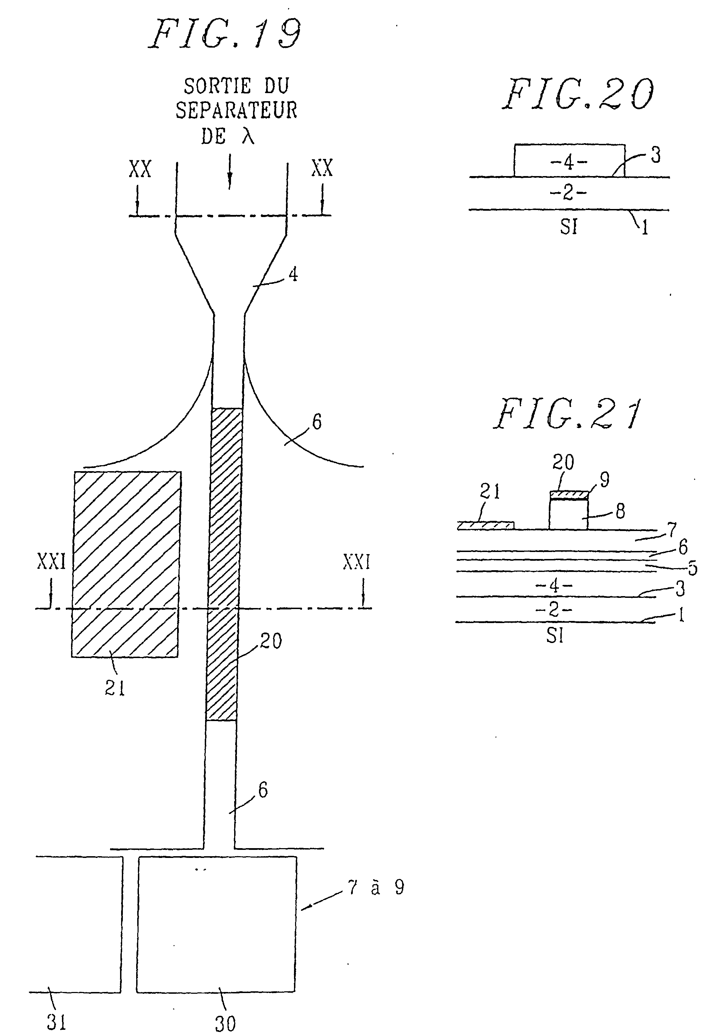

En outre, le dispositif optoélectronique conforme à l'invention comprend au moins un adaptateur de mode T, plus précisément un adaptateur de mode T en amont et respectivement en aval de l'amplificateur optique AO et un adaptateur de mode T en amont de chaque photodétecteur D, selon le mode de réalisation des figures 2 à 16, et un adaptateur de mode T en amont de chaque amplificateur optique AO, selon le mode de réalisation des figures 17 à 21.

Les différents éléments précités T, AO, MUX et D sont reliés grâce à un guide optique référencé G, avantageusement un guide large mode.

Par ailleurs, sur la figure 1 on a schématisé sous la référence F une fibre optique amenant le signal d'entrée sur le dispositif optoélectronique.

Les adaptateurs de mode T ont pour fonction de permettre le couplage avec la fibre d'entrée F et avec les composants AO et D à faible mode, en permettant le transfert du mode large du guide G à un faible mode compatible avec ces composants.

L'amplificateur optique AO a pour fonction d'amplifier optiquement le signal reçu.

Le filtre séparateur MUX a pour fonction de séparer les différentes longueurs d'onde du signal et de réduire le bruit de l'amplificateur optique.

Le (chaque) photodétecteur D a pour fonction de détecter le signal reçu pour chaque longueur d'onde.

De préférence, le photodétecteur D est relié à un amplificateur électrique AE. Il peut s'agir d'un amplificateur électrique classique. Pour cette raison, la structure de ce dernier ne sera pas décrite dans le détail par la suite.

On va maintenant décrire la structure du dispositif optoélectronique représentée sur les figures 2 et 3 annexées.

Le dispositif représenté sur les figures 2 et 3 comprend un tronçon d'entrée de guide optique G1 relié à un amplificateur optique AO par l'intermédiaire d'un adaptateur de mode T1 d'entrée. Cet amplificateur optique AO est couplé par l'intermédiaire d'un second adaptateur de mode T2 de sortie et d'un second tronçon de guide optique G2 au filtre séparateur de longueur d'onde MUX.

Ces deux adaptateurs de mode T1 et T2, respectivement d'entrée et de sortie, sont symétriques. L'adaptateur d'entrée T1 transfert le mode large du guide G1 en un faible mode compatible avec l'amplificateur optique AO. En revanche, l'adaptateur de sortie T2 transfert le mode faible de l'amplificateur optique AO en un large mode compatible avec le guide G2.

Selon le mode de réalisation des figures 2 et 3, considéré comme préférentiel dans le cadre de l'invention, le filtre séparateur de longueur d'onde MUX comprend un dioptre plan d'entrée DP1, un dioptre plan de sortie DP2 et un réseau de guides à miroirs placé entre les dioptres DP1 et DP2 pour définir entre ceux-ci des trajets optiques de longueurs différentes.

Sur la figure 2, les différentes voies du réseau de guides à miroirs placées entre les dioptres DP1 et DP2 sont référencées mux1 à muxp.

Plus précisément, selon le mode de réalisation particulier représenté sur la figure 2, chaque voie mux1 à muxp du réseau de guides à miroirs comprend quatre tronçons de guides rectilignes g1mux, g2mux, g3mux, g4mux et trois miroirs M1, M2,M3.

Les tronçons de guide g1mux à g4mux ont des longueurs différentes d'une voie à l'autre.

Les deux tronçons d'extrémité de guide de chaque voie référencés g1mux et g4mux sont de préférence alignés et parallèles aux guides G1 et G2 précités.

Les deux tronçons intermédiaires g2mux et g3mux sont en revanche inclinés par rapport aux tronçons d'extrémité g1mux et g4mux. Les tronçons g1mux, g2mux, g3mux, g4mux de guide et les miroirs M1, M2, M3 composant le filtre séparateur MUX peuvent présenter un plan de symétrie P perpendiculaire aux tronçons d'entrée G1, G2 du guide optique.

Le dioptre de sortie DP2 combine les signaux provenant des différentes voies mux1 à muxp, déphasés en raison de la différence de longueur de trajet parcouru.

Les dioptres plans DP1 et DP2 correspondent à des zones non guidées latéralement, c'est-à-dire des zones de guidage plan. La structure des dioptres plans est la même que celles des guides à large mode. Ainsi, l'ensemble dioptre plan et guide peut être réalisé en même temps. Leur fonction est identique à celle d'une lentille classique. L'image à la sortie de la lentille se calcule par transformée de Fourier. Ceci permet d'obtenir une séparation spatiale des longueurs d'onde résultat d'une différence de longueur des guides entre les deux dioptres DP1 et DP2.

Le dioptre de sortie DP2 est ensuite couplé par l'intermédiaire d'au moins un tronçon de guide optique G3, et par l'intermédiaire d'un adaptateur de mode T à au moins un photodétecteur D.

Ce photodétecteur D délivre ainsi un signal électrique correspondant au signal d'une longueur d'onde spécifique séparée en sortie du filtre MUX, à l'amplificateur électrique AE, ou tout autre organe de traitement approprié.

Plus précisément, de préférence, il est prévu en sortie du dioptre DP2, n voies, avec n supérieur à 1, comprenant chacune un tronçon de guide optique G3 couplé par l'intermédiaire d'un adaptateur de mode T à un photodétecteur spécifique D. Ainsi, chaque photodétecteur D délivre un signal représentatif d'une longueur d'onde spécifique associée.

Sur la figure 3, le substrat semi-isolant portant le dispositif optoélectronique est référencé SI.

Sur la même figure 3 on a schématisé sous forme de traits incurvés la direction de propagation de l'onde optique dans le dispositif.

Sur la même figure 3 on a référencé GLM le guide large mode G1 placé en amont de l'amplificateur optique AO pour faciliter le couplage avec la fibre d'entrée F. Enfin, sur la figure 3, on a référencé SH un guide simple hétérostructure composant l'adaptateur de mode T en entrée du photodétecteur D.

On notera que le premier miroir M1 est situé au niveau de la jonction entre les tronçons de guide optique g1mux, g2mux, le second miroir M2 est placé au niveau de la jonction entre les tronçons de guide optique g2mux et g3mux, tandis que le troisième miroir M3 est placé au niveau de la jonction entre les tronçons de guide g3mux et g4mux.

Les miroirs M1 à M3 ont pour fonction de renvoyer dans le tronçon aval de guide le signal reçu en provenance du tronçon amont.

On a représenté sur la figure 4 une variante de réalisation conforme à la présente invention du filtre séparateur MUX comprenant non plus quatre tronçons de guide optique et trois miroirs comme illustré sur la figure 2, mais cinq tronçons de guide optique g1mux, g2mux, g3mux, g4mux et g5mux, et quatre miroirs associés M1, M2, M3 et M4, pour chaque voie mux1 à muxp placée entre les dioptres DP1 et DP2. Cette structure à cinq tronçons et quatre miroirs permet d'optimiser la différence de longueur entre les différentes voies mux1 à muxp, entre les dioptres DP1 et DP2.

Plus précisément encore, selon le mode de réalisation non limitatif représenté sur la figure 4, les deux tronçons d'extrémités g1mux et g4mux de chaque voie mux1 à muxp sont de préférence alignés et parallèles aux guides d'entrée G1 et G2, les deux tronçons g2mux et g3mux qui leur sont respectivement reliés s'étendent perpendiculairement à ces tronçons d'extrémité g1mux et g4mux, et enfin le tronçon additionnel intermédiaire g5mux qui assure la liaison entre les tronçons g2mux et g3mux est de préférence parallèle aux tronçons g1mux et g4mux.

Le miroir M1 est placé au niveau de la jonction entre g1mux et g2mux. Le miroir M2 est placé au niveau de la liaison entre g2mux et g5mux. Le miroir M3 est placé au niveau de la jonction entre les tronçons g5mux et g3mux. Enfin, le miroir M4 est placé au niveau de la jonction entre les tronçons g3mux et g4mux.

Là encore les tronçons de guide g1mux à g5mux ont des longueurs différentes d'une voie à l'autre. Par ailleurs, les miroirs M1 à M4 ont pour fonction de renvoyer vers le tronçon aval le signal reçu en provenance du tronçon amont.

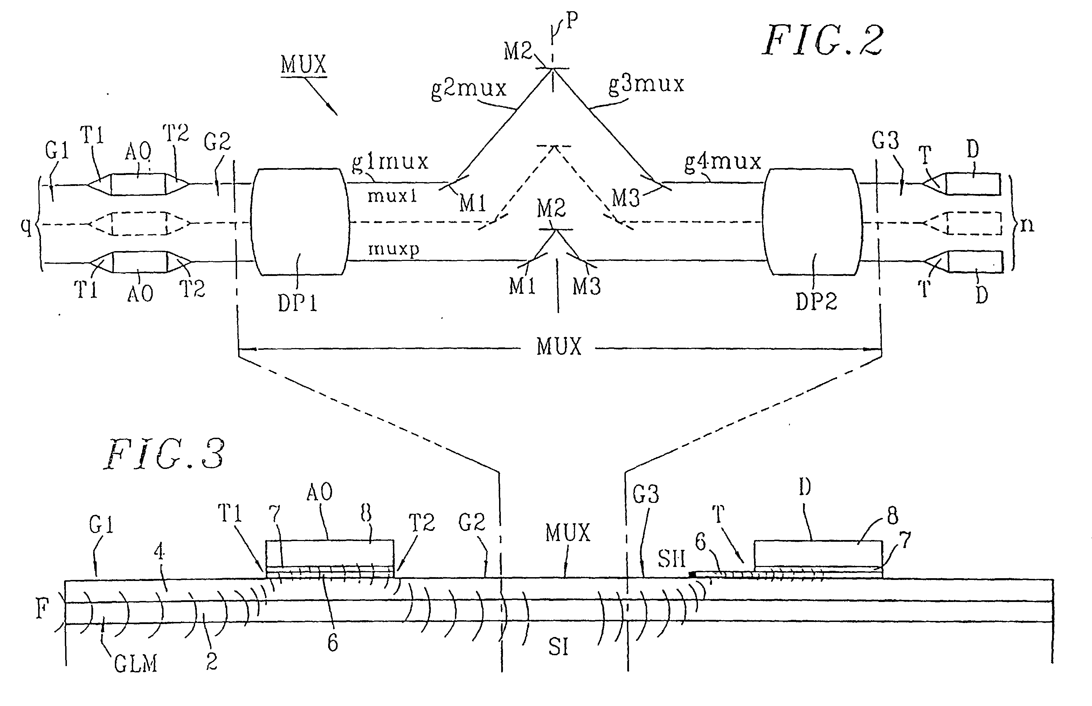

On va maintenant préciser un mode de réalisation préférentiel du dispositif optoélectronique schématisé sur les figure 2 et 3 en regard des figures 5 à 16.

Ce dispositif est obtenu à partir du dépôt sur un substrat semi-isolant, à l'aide d'une seule épitaxie, des neuf couches de matériau semiconducteur indiquées dans le tableau 1.

**TABLEAU 1**

| COUCHES | | MATERIAU X | EPAISSEURS (µm) | TYPE | INTER (µm) | PORTEURS (cm-3) |
|---|---|---|---|---|---|---|
| diode | 9 | GaInAs | 0,0500 | p+ | | >5x10¹⁸ |
| | 8 | InP | 0,8 | p+ | | >5x10¹⁸ |
| | 7 | GaInAsP | 0,3 | n- | 1,6 | <5x10¹⁵ |
| guide | 6 | GaInAsP | 0,35 | n- | 1,3 | <5x10¹⁵ |
| | 5 | InP | 0,4 | n+ | | >5x10¹⁸ |
| guide adaptateur | 4 | InP | 0,6 | n- | | <5x10¹⁵ |
| | 3 | InGaAsP | 0,13 | n- | | <5x10¹⁵ |
| | 2 | InP | 1 | n- | | <5x10¹⁵ |
| | 1 | InGaAsP | 0,13 | n- | | <5x10¹⁵ |
| Substrat | | SI InP | 2'' (100) | SI | | |

Ces différentes couches permettant l'intégration de l'ensemble du dispositif optoélectronique sont déposées en une seule épitaxie sur le substrat semi-isolant.

Les quatre premières couches épitaxiées constituent les couches du guide à large mode à structure diluée. Cette structure possède une faible biréfringence facilitant l'indépendance à la polarisation.

Les deux couches suivantes (couches 5 et 6) constituent un guide simple hétérostructure permettant la transition de mode large à mode étroit et réciproquement.

La couche 7, quaternaire dopée n est placée au-dessus du guide et permet de prendre le contact du photodétecteur D et de l'amplificateur optique AO.

Pour terminer les deux dernières couches 8 et 9, constituées de matériau binaire et quaternaire dopé p permet à la fois l'amplification et la détection par inversion de polarisation électrique.

Les adaptateurs de mode T peuvent faire l'objet de diverses variantes de réalisation.

Ainsi, le couplage mode large à mode étroit (et inversement) peut être obtenu en taillant en biseau une couche guidante, par marches ou directement, ou encore en taillant la couche guidante en pointe grâce à une ou plusieurs lithographies et attaques par exemple. En variante, pour éviter l'emploi d'insolation sur tranches, très contraignante, lors de la réduction en pointe de la couche guidante, on peut non pas tailler la couche guidante en pointe, mais utiliser une gravure totale par zones, à pas variables, d'un ruban composant cette couche guidante, comme décrit dans la demande de brevet déposée en France le 2 Mai 1994 sous le n° 94 05304. Par "pas variables", on entend que les zones gravées, c'est-à-dire éliminées totalement, ont des épaisseurs progressivement croissantes en éloignement du ruban composant la couche guidante et que par ailleurs les éléments discrets de cette couche guidante préservée entre deux zones gravées, ont inversement des épaisseurs progressivement décroissantes en éloignement du ruban composant la couche guidante.

Cependant, selon le mode de réalisation préférentiel de l'invention, chaque adaptateur de mode T présente une forme en sablier comprenant une partie d'entrée large mode, une zone de décroissance en largeur pour pousser le mode en profondeur et une zone de croissance en largeur qui permet le transfert de mode, du mode large vers un mode faible (la disposition symétrique étant utilisée pour opérer au contraire le transfert d'un mode faible en sortie par exemple d'amplificateur optique, vers un mode large de guide).

Dans la zone de décroissance, le ruban composant l'adaptateur de mode décroit en largeur dans le sens de la propagation du signal optique.

La région de transition entre la zone de décroissance et la zone de croissance n'est pas formée d'une pointe (démarrant à zéro µm par définition) mais d'une pointe tronquée, par exemple démarrant avec une largeur de l'ordre de 2µm. Une telle extrémité tronquée est plus facile à réaliser qu'une pointe pure ou encore qu'une pointe de faible largeur (1µm).

La réalisation de l'adaptateur de mode en forme de sablier est donc particulièrement importante parce qu'elle facilite la technologie. Elle permet par exemple l'utilisation d'une technique de lithographie optique peu coûteuse.

Comme on l'a schématisé sur la figure 3, le mode se trouve dans sa position la plus profonde lorsqu'il atteint la gorge la plus étroite du sablier. On obtient à ce niveau la transition mode large-mode guidé.

Puis vient la zone de croissance, au niveau de laquelle le ruban croît en largeur dans le sens de la propagation optique.

Le passage du mode large d'entrée à un mode plus étroit se fait dans la zone de croissance, en remontant.

Dans le cadre de l'invention, la structure adaptateur de mode T est ainsi utilisée comme guide d'onde.

Plus précisément, selon le mode de réalisation représenté sur les figures 2 et 3, il est prévu un adaptateur de mode en entrée et en sortie de l'amplificateur optique AO et en entrée du photodétecteur D. Ainsi, le transfert de mode se fait uniquement au niveau d'une fonction donnée : l'amplificateur optique (avec en sortie le retour vers le guide G2 après amplification) ou le photodétecteur D (sans retour vers le guide puisque tout a été absorbé).

On notera par ailleurs à l'examen de la figure 2, que de préférence il est prévu q voies d'entrée comprenant chacune un tronçon de guide G1, un adaptateur de mode T1 d'entrée, un amplificateur optique AO, un second adaptateur de mode T2 de sortie et un tronçon de guide optique G2 en amont du dioptre d'entrée DP1. Cette disposition offre la possibilité de pouvoir ajuster les longueurs d'onde du peigne de sortie. Cependant, bien entendu, en pratique, une seule voie d'entrée sera généralement utilisée.

L'amplificateur optique AO est formé à partir des couches 7, 8 et 9 précitées, plus précisément par gravure d'un ruban dans les couches supérieures 8 et 9 et dépôt de métallisations respectives référencées 20 et 21 sur les figures annexées, l'une sur la couche supérieure 19 dopé p, l'autre sur la couche 7 dopé n mise à jour.

Typiquement l'écart L1 entre la métallisation 21 prévue sur la couche 7 et le ruban formé dans les couches 8 et 9 et pourvu de la métallisation 20, est de l'ordre de 4 à 5µm.

Comme on l'a indiqué précédemment, pour réduire les dimensions du dispositif, selon l'invention chaque voie du filtre séparateur de longueur d'onde MUX est de préférence constituée d'un ensemble de guides g1mux à g4mux associés à des miroirs M1 à M3 remplaçant les virages connus des documents Verbeek et Zirngibl, entre les dioptres plans DP1 et DP2.

Ainsi, l'invention permet de substituer au spectromètre à réseau de guides (SRG) classique, un spectromètre de taille réduite à réseau de guides g1mux à g4mux et miroirs M1 à M3.

Les miroirs M1 à M3 sont réalisés dans les couches 1 à 4 utilisées pour former les structures adaptateurs de mode T. Ces structures adaptateurs de mode T, ayant un mode large, sont des structures à un seul matériau InP contenant de fines couches (inférieure à 0,13µm) de GalnAsP. Ainsi l'homogénité de matériau existant dans les structures adaptateurs de mode est plus propice à une gravure uniforme pour la réalisation des miroirs.

En effet, les structures binaire/quaternaire/binaire (InP/GaInAsP(=0,5µm)/InP) de mode étroit sont difficiles à graver de façon uniforme.

Les miroirs M1 à M3 peuvent, il est vrai, induire certaines pertes en raison du manque d'uniformité dans la gravure des couches. Cependant, les miroirs permettent de réduire notablement les pertes de propagation en diminuant la taille des dispositifs et par conséquent les longueurs de guide.

Les miroirs M1 à M3 composant le filtre séparateur de longueur d'onde MUX présentent un autre intérêt par rapport aux virages à fort rayon de courbure classiques : éviter la correction des longueurs de guide en fonction de la courbure des virages (voire page 64, ligne 16 du document Verbeek). Verbeek indique en effet clairement que la constante de propagation (ou l'indice) dépend du rayon de courbure. Ainsi la différence de longueur entre deux guides successifs n'est pas constante. Elle dépend de la courbure. En revanche, selon l'invention, le filtre séparateur MUX ne comprend pas des virages, mais des miroirs, qui permettent à tous les guides de circuit d'avoir la même constante de propagation. En plus, le même comportement en TE et TM est préservé, ce qui n'est pas le cas dans les virages classiques. Cet avantage permet de réduire les temps de simulation et donc de conception.

Le (chaque) photodétecteur D peut également faire l'objet de diverses variantes de réalisation.

Cependant, selon la présente invention, chaque photodétecteur D comprend de préférence deux diodes identiques placées côte à côte et montées tête-bêche.

En pratique, ces deux diodes composant chaque photodétecteur D peuvent être formées en déposant, sur un même substrat, des couches constituant un premier empilement de couches semiconductrices constituant une première diode, et un second empilement identique au premier et placé à côté de celui-ci, ce second empilement constituant une seconde diode, des moyens de polarisation étant reliés à la première diode à travers la seconde, les deux diodes étant ainsi montées tête-bêche, l'une étant polarisée en inverse et l'autre en direct.

En pratique, le photodétecteur peut comprendre deux diodes PIN ou deux diodes INP.

En fonctionnement, l'une des diodes se trouve être polarisée en inverse et sert de moyens de photodétection tandis que l'autre polarisée nécessairement en direct, sert à conduire le courant de photodétection.

Cette structure de photodétecteur présente l'avantage de nécessiter une seule et même métallisation (et non pas deux comme cela était classique antérieurement) et ce sur un seul niveau (et non pas deux comme cela était classique).

On notera également que grâce à cette structure de photodétecteur constituée de deux diodes tête-bêche, il est possible de faire jouer à chaque diode le rôle de photodétecteur (l'autre diode assurant alors la circulation du photocourant). On peut donc associer à une telle structure non plus un mais deux guides optiques qui passeront respectivement sous les deux diodes. En polarisant en inverse l'une ou l'autre des diodes, on pourra travailler avec l'un ou l'autre des guides.

Si l'une des voies vient à être défectueuse, on pourra toujours utiliser l'autre en transférant la fonction de photodétection sur la diode correspondante. Ce transfert est immédiat puisqu'il suffit de faire basculer le sens de polarisation. La durée de vie de ce dispositif est donc augmentée et par la même sa fiabilité.

Le photocourant est engendré par la partie de la structure photodétectrice appauvrie en porteurs de charges et polarisée en inverse. Il traverse la partie de la structuré en direct uniquement si la polarisation appliquée compense son appauvrissement à la tension V = 0. En d'autres termes, avec une polarisation nulle, les deux zones sont appauvries. En éclairant, l'une des parties de la structure le photocourant créé sera bloqué par l'autre partie appauvrie. En appliquant une tension, une partie de la structure se trouve polarisée en inverse et reste appauvrie tandis que l'autre, polarisée, en direct, devient conductrice.

La première diode fonctionnant dans le sens inverse (le photocourant créé circule dans le sens bloqué) se comporte donc comme un générateur de courant qui débite dans la seconde diode polarisée dans le sens passant (direct). Bien que la structure empêche le courant extérieur de passer, le photocourant pourra être détecté.

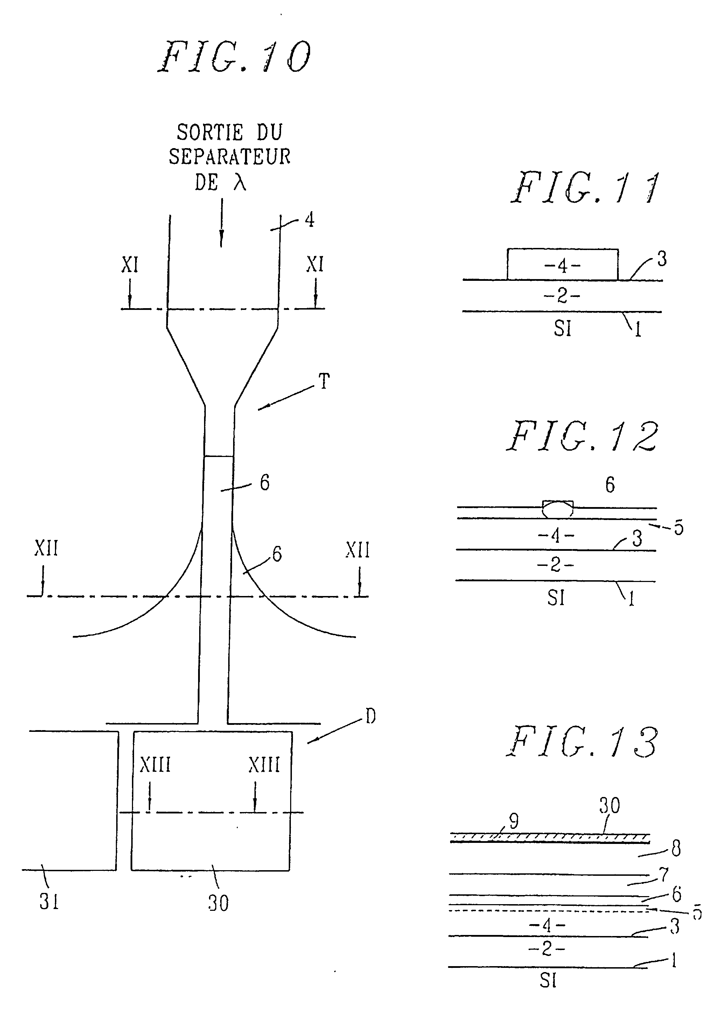

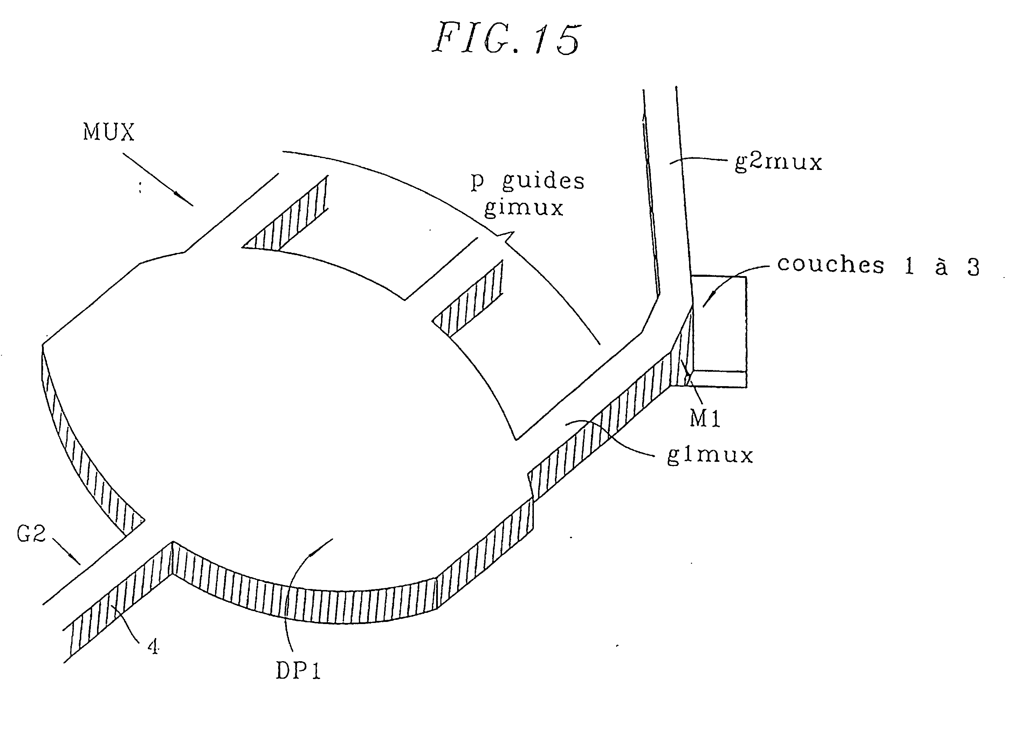

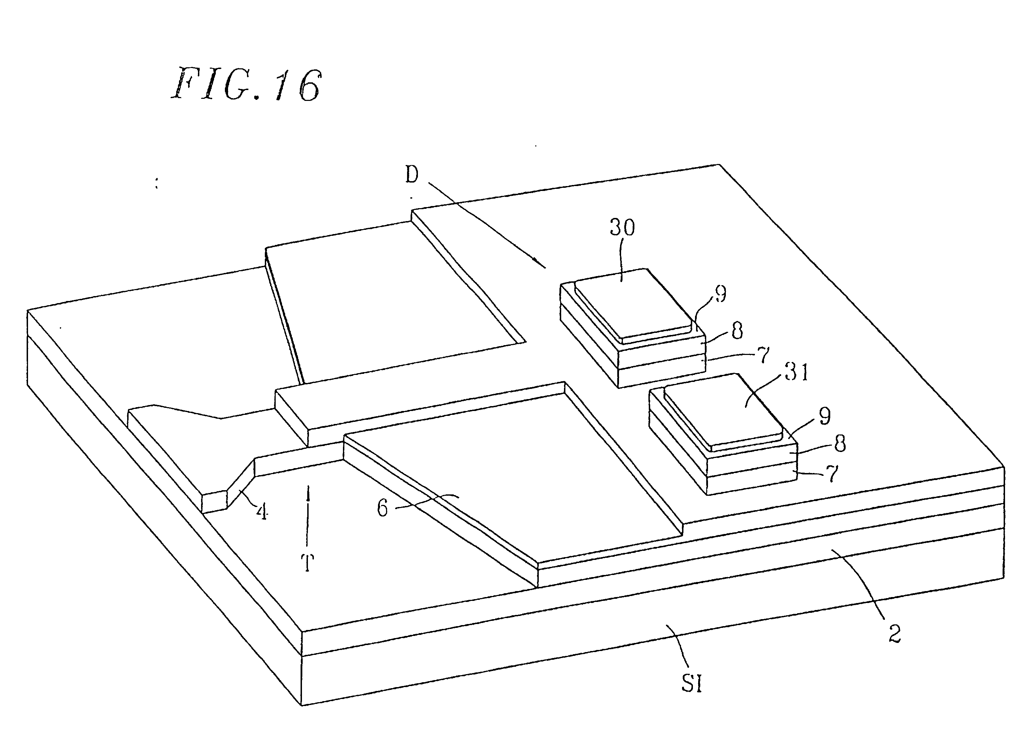

Plus précisément encore, la structure représentée sur les figures 5 à 16, peut être réalisée, après dépôt par épitaxie des neuf couches indiquées dans le tableau 1 précité, à l'aide des étapes suivantes :
1) dépôt de la métallisation 20 du contact p sur la zone de la couche supérieure 9 destinée à former l'amplificateur optique AO (voir figures 5, 7 et 14) et dépôt des métallisations 30, 31 de contact p sur les zones de la couche supérieure 9 destinées à former les deux empilements constituant les diodes tête-bêche, comme illustré sur les figures 10, 13 et 16 ; puis réalisation du ruban constituant l'amplificateur optique AO comme illustré sur les figures 5, 7 et 14 ainsi que les pavés constituant les empilements de la structure photodétectrice comme illustré sur les figures 10, 13 et 16, par gravure des couches 8 et 9, avec auto-alignement sur les métallisations précitées 20, 30, 31.
   Plus précisément, il est réalisé un ruban d'amplificateur optique AO pour chacune des 9 voies d'entrée, et deux pavés longitudinaux respectivement les deux diodes tête-bêche d'un photodétecteur pour chacune des voies de sortie.
2) passivation des pavés et rubans constituant la structure photodétectrice D et les amplificateurs optiques AO.
3) retrait de la couche absorbante 7 autour des empilements constituant les structures photodétectrices D et sur le guide à simple hétérostructure SH formé des couches 5 et 6, à faible largeur de mode, situé en amont de celles-ci, comme on le voit sur la figure 16. Ainsi, les empilements constituant les diodes tête-bêche, sont formés des couches 7, 8 et 9.
4) gravure du ruban guide constituant le guide G3, dans la couche 6 comme on le voit sur la figure 10.
5) gravure profonde dans la couche 4, pour réalisation des adaptateurs de mode en sablier et des guides à mode large comme on le voit sur les figures 5, 6, 9, 10, 11, 14 ct 16 et pour réalisation des dioptres DP1, DP2 et des tronçons de guide gimux du filtre MUX comme illustré sur la figure 15. Ainsi les dioptres DP1, DP2 et les tronçons de guide gimux sont réalisés dans la couche binaire.
6) retrait de la couche guide à petit mode formée de la couche 6 au-dessus des guides larges, et
7) gravure ionique réactive (Reactive Ion Etching-RIE) jusqu'au substrat semi-isolant, dans les couches 1 à 4, pour la réalisation des miroirs M1 à M3, comme cela est schématisé sur la figure 15. Ainsi, c'est la différence d'indice entre l'air et le semiconducteur qui induit la réflexion.

Il faut noter que grâce au processus qui vient d'être décrit, l'intégration du guide à mode large avec l'amplificateur optique (figure 5) et l'intération des guides à mode large avec le détecteur (figure 10) sont opérés sans reprise d'épitaxie.

Cette intégration, grâce notamment à l'utilisation d'adaptateurs de mode en forme de sablier, permet de relaxer les tolérances de fabrication.

Au niveau de l'amplificateur optique, la structure guide est constituée par une structure amplificatrice.

Dans le cas du détecteur, la structure guide est une structure simple hétérostructure.

Les couches détectrices, absorbantes, 7 à 9 sont retirées dans la partie transition de mode, pour éviter de réaliser une diode en pointe avec un plus fort courant de fuite.

On a représenté sur la figure 17 une autre variante de réalisation de photodétecteur conformes à la présente invention, selon laquelle il est prévu un amplificateur optique AO sur chacune des n voies de sortie, juste avant chaque photodétecteur D. Ces amplificateurs optiques AO permettent de régler séparément le niveau des différents signaux de longueur d'onde données. Il est ainsi possible de relever le niveau du signal de longueur d'onde λᵢ, ayant subi des pertes relatives à la traversée du dispositif.

II est aussi possible, grâce à cette disposition, de ne récupérer qu'une longueur d'onde en sortie, en appliquant un courant à l'amplificateur optique se trouvant sur le trajet spécifique du signal λᵢ.

Dans ce cas, de préférence, l'adaptation de mode n'est utilisée qu'une seule fois sur l'ensemble du circuit, juste en amont de l'amplificateur optique. Elle permet le passage du guide à mode large à l'amplificateur optique AO à faible mode. Les mêmes couches de l'amplificateur optique AO sont utilisées pour le photodétecteur D. L'amplificateur est polarisé en direct et le détecteur en inverse.

Ainsi, on retrouve sur la figure 17, q voies d'entrée comprenant chacune un tronçon de guide optique G1, un filtre séparateur de longueur d'onde MUX, comprenant un dioptre d'entrée DP1, un dioptre de sortie DP2 et entre ceux-ci un réseau de P guides optiques g1mux à g4mux associés à des miroirs M1 à M3, et n voies de sortie comprenant chacune un tronçon de guide optique G3 menant à un adaptateur de mode T et de là à un amplificateur optique AO et un photodétecteur D.

Les détails de réalisation de cette structure apparaissent sur les figures 19 à 21.

Pour l'essentiel, cette structure est réalisée à partir des 9 couches mentionnées dans le tableau 1, déposées par épitaxie, et à l'aide d'une séquence d'étapes comparables à celles décrites précédemment en regard des figures 5 à 16.

Bien entendu la présente invention n'est pas limitée aux modes de réalisation particuliers qui viennent d'être décrits mais s'étend à toute variante conforme à son esprit.

En particulier, le filtre séparateur de longueur d'onde pourra faire l'objet d'autres variantes de réalisation comportant des nombres de tronçons des guides optiques et des miroirs entre les dioptres DP1 et DP2 différents de ceux illustrés sur les figures 2 et 4.

Dans le cadre de l'invention, on peut également envisager, pour opérer le déphasage requis, de combiner des miroirs comme illustré sur les figures 2 et 4 définissant des trajets optiques présentant des longueurs physiques différentes, et un changement d'indice, d'une voie à l'autre, afin d'optimiser les différences entre les trajets optiques parcourus.

Par rapport à la technique antérieure, la présente invention offre de nombreux avantages.

Par rapport au document R. Dall' Ara et al., l'utilisation préconisée selon l'invention d'un guide non absorbant (faible mode) comme intermédiaire entre l'amplificateur et le détecteur, permet d'éviter des pertes aux interfaces.

L'intégration monolithique de l'ensemble des circuits composant le dispositif optoélectronique permet notamment d'éliminer les problèmes d'alignement entre chaque circuit composant le dispositif optoélectronique, d'éviter les pertes de raccordement, et de diminuer ainsi le coût du dispositif.

En outre, le dispositif optoélectronique conforme à la présente invention peut être obtenu sans reprise d'épitaxie. Il est en outre indépendant de la polarisation optique (TE et PM).

L'utilisation d'adaptateurs de mode en forme de sablier permet une intégration simple avec des tolérances relaxées sur la fabrication.

L'utilisation d'un filtre séparateur de longueur d'onde à base de miroirs permet de réduire les dimensions du dispositif par rapport aux solutions antérieures SRV et/ou SRG.

L'invention permet également de réduire les pertes de propagation en réduisant les dimensions du dispositif.

L'invention peut bien entendu faire l'objet de nombreuses variantes. A titre d'exemple non limitatif, on peut citer la réalisation d'un filtre séparateur de longueur d'onde comprenant un démultiplexeur comportant 74 voies muxn, un nombre de 8 voies d'entrée du dispositif et un nombre de 8 voies de sortie.

## Revendications

1. Dispositif optoélectronique destiné à la séparation de longueurs d'onde différentes d'un signal d'entrée composite et la détection de l'une au moins des longueurs d'onde séparées, comprenant: au moins un filtre (MUX) apte à séparer différentes longueurs d'onde du signal, au moins un photodétecteur (D) situé en aval du filtre séparateur, au moins un adaptateur de mode (T) situé en amont du filtre séparateur ou entre le filtre séparateur et le photodétecteur, et au moins un guide (G) assurant la liaison entre les éléments précités, **caractérisé par le fait qu'**il comprend en outre au moins un amplificateur optique (AO), que le guide (G) est un guide large mode, que l'adaptateur de mode (T) est disposé en amont immédiat de l'amplificateur optique et adapté pour transférer le mode large d'un élément de guide (G1;G3) raccordé en son amont en un mode faible compatible avec l'amplificateur optique, et que le filtre séparateur de longueur d'onde (MUX) comprend deux dioptres (DP1 et DP2) et une série de voies de guidage (mux1-muxp) s'étendant entre les dioptres (DP1, DP2) pour définir des trajets optiques de longueurs différentes, chaque voie de guidage comprenant une pluralité de tronçons de guide rectilignes (g1mux-g4mux) d'inclinaison différente couplés les uns aux autres par des miroirs de renvoi respectifs (M1-M4), tous les éléments précités étant intégrés par dépôt en une seule épitaxie sur un substrat semi-isolant (SI).

2. Dispositif selon la revendication 1, **caractérisé par le fait qu'**il comprend au moins une voie d'entrée placée en amont du filtre séparateur (MUX) et comportant l'adaptateur de mode (T), l'amplificateur optique (AO) et l'élément de guide large mode (G1) raccordé en amont de l'adaptateur de mode, ainsi qu'un second adaptateur de mode (T) situé en aval immédiat de l'amplificateur optique, et un second élément de guide large mode (G2) reliant le second adaptateur de mode au filtre séparateur; et au moins une voie de sortie placée en aval du filtre séparateur (MUX) et comprenant un troisième elément de guide (G3) reliant ce filtre à un troisième adaptateur de mode (T) disposé en amont immédiat du photodétecteur (D).

3. Dispositif selon la revendication 1, **caractérisé par le fait que** l'adaptateur de mode (T) et l'amplificateur optique (AO) sont placés en aval du filtre séparateur de longueur d'onde (MUX), et en amont du photodétecteur (D).

4. Dispositif selon l'une des revendications 1 ou 3, **caractérisé par le fait qu'**il comprend au moins une voie d'entrée placée en amont du filtre séparateur (MUX) et comprenant un élément de guide optique (G1) raccordé à ce filtre, et au moins une voie de sortie placée en aval du filtre séparateur (MUX) et comprenant l'élément de guide large mode (G3) raccordé en amont de l'ensemble adaptateur de mode (T)-amplificateur optique (AO) suivi du photodétecteur (D).

5. Dispositif selon l'une des revendications 1 à 4, **caractérisé par le fait que** le filtre séparateur de longueur d'onde (MUX) est réalisé dans un seul matériau binaire contenant de fines couches de matériau quaternaire.

6. Dispositif selon la revendication 5, **caractérisé par le fait que** le filtre séparateur de longueur d'onde (MUX) est réalisé dans une structure à base d'InP contenant de fines couches GaInAsP.

7. Dispositif selon l'une des revendications 1 à 6, **caractérisé par le fait que** chaque voie de guidage (mux1-muxp) du filtre séparateur de longueur d'onde (MUX) est formée de quatre tronçons de guide optique rectilignes (g1mux à g4mux) associés à trois miroirs de renvoi (M1, M3).

8. Dispositif selon l'une des revendications 1 à 6, **caractérisé par le fait que** chaque voie de guidage (mux1-muxp) du filtre séparateur de longueur d'onde (MUX) comprend cinq tronçons de guide optique rectilignes (g1mux à g5mux) associés à quatre miroirs de renvoi (M1, M4).

9. Dispositif selon l'une des revendications 1 à 8, **caractérisé par le fait que** l'(chaque)adaptateur de mode (T) est formé par gravure en forme de sablier.

10. Dispositif selon la revendication 9, **caractérisé par le fait que** l'(chaque)adaptateur de mode en sablier comprend une partie d'entrée large mode, une zone de décroissance en largeur pour pousser le mode en profondeur et une zone de croissance en largeur qui permet le transfert du mode large vers un mode étroit, ou inversement.

11. Dispositif selon l'une des revendications 9 ou 10, **caractérisé par le fait que** l'(chaque)adaptateur de mode (T) en forme de sablier comprend une gorge de largeur non nulle.

12. Dispositif selon l'une des revendications 9 à 11, **caractérisé par le fait que** l'(chaque) adaptateur de mode comprend des couches minces (1 et 3) pour diluer le mode.

13. Dispositif selon l'une des revendications 1 à 12, **caractérisé par le fait qu'**il est réalisé par des gravures dans une structure déposée à l'aide d'une seule épitaxie et comprenant des premières couches (1 à 4) constituant un guide à large mode à structure diluée, des couches (5 et 6) formant un guide simple hétérostructure permettant une transition de mode large à mode étroit et réciproquement et des couches (7 à 9) permettant à la fois l'amplification et la détection par inversion de polarisation électrique.

14. Dispositif selon l'une des revendications 1 à 13, **caractérisé par le fait qu'**il comprend une couche dopée n au-dessus d'une structure guide, pour permettre de prendre le contact du photodétecteur (P) et de l'amplificateur optique (AO).

15. Dispositif selon l'une des revendications 1 à 14, **caractérisé par le fait que** l'amplificateur optique (AO) est réalisé à partir de deux couches de matériau semiconducteur superposées et réalisation d'un ruban par gravure dans la couche supérieure.

16. Dispositif selon l'une des revendications 1 à 15, **caractérisé par le fait que** le photodétecteur (D) est constitué par un premier empilement de couches semiconductrices constituant une première diode et un second empilement identique au premier et placé à côté de celui-ci, ce second empilement constituant une seconde diode, et des moyens de polarisation reliés à la première diode à travers la seconde, les deux diodes étant ainsi montées tête bêche, l'une étant polarisée en inverse et l'autre en direct.

17. Dispositif selon l'une des revendications 1 à 16, **caractérisé par le fait que** les voies de guidage du filtre séparateur de longueur d'onde (MUX) possèdent des indices différents.

18. Dispositif selon l'une des revendications 1 et 3 à 17, excepté lorsque l'une quelconque des revendications 5 à 17 se trouve rattachée à la revendication 2, **caractérisé par le fait qu'**un autre adaptateur de mode (T) est placé dans le circuit optique en amont du détecteur (D) pour faciliter les transferts de mode.

## Claims

1. An optoelectronic device for separating different wavelengths of a composite input signal, and for detecting at least one of the separated wavelengths, the device comprising: at least one filter (MUX) capable of separating different wavelengths of the signal, at least one photodetector (D) situated downstream of the separator filter, at least one mode adapter (T) situated upstream of the separator filter or between the separator filter and the photodetector, and at least one waveguide (G) interconnecting the above-mentioned elements, the device being **characterized by** the facts that it further comprises at least one optical amplifier (AO), that the waveguide (G) is a broad-mode waveguide, that the mode adapter (T) is disposed immediately upstream of the optical amplifier and is adapted to transfer the broad-mode of a waveguide element (G1; G3) connected at its upstream end into a narrow mode that is compatible with the optical amplifier, and that the wavelength separator filter (MUX) comprises two slab waveguides (DP1 and DP2) and a series of waveguide channels (mux1 to muxp) extending between the slab waveguides (DP1, DP2) to define light paths of different lengths, each waveguide channel comprising a plurality of rectilinear waveguide sections (g1mux-g4mux) of different inclinations coupled together by respective mirrors (M1-M4), all the above-mentioned elements being integrated by deposition in a single epitaxial growth process on a semi-insulating substrate (SI).

2. A device according to claim 1, **characterized by** the fact that it comprises at least one input channel placed upstream of the separator filter (MUX) and including the mode adapter (T), the optical amplifier (AO), and the broad-mode waveguide element (G1) connected upstream of the mode adapter, together with a second mode adapter (T) situated immediately downstream of the optical amplifier, and a second broad-mode waveguide element (G2) connecting the second mode adapter to the separator filter; and at least one output channel placed downstream of the separator filter (MUX) and comprising a third waveguide element (G3) connecting said filter to a third mode adapter (T) disposed immediately upstream of the photodetector (D).

3. A device according to claim 1, **characterized by** the fact that the mode adapter (T) and the optical amplifier (AO) are placed downstream of the wavelength separator filter (MUX) and upstream of the photodetector (D).

4. A device according to claim 1 or claim 3, **characterized by** the fact that it comprises at least one input channel placed upstream of the separator filter (MUX) and comprising a light guide element (G1) connected to said filter, and at least one output channel placed downstream of the separator filter (MUX) and comprising the broad-mode waveguide element (G3) connected upstream of the mode adapter (T) and optical amplifier (AO) unit followed by the photodetector (D).

5. A device according to any one of claims 1 to 4, **characterized by** the fact that the wavelength separator filter (MUX) is made of a single binary material containing thin layers of quaternary material.

6. A device of claim 5, **characterized by** the fact that the wavelength separator filter (MUX) is made of a structure based on InP containing thin GalnAsP layers.

7. A device according to any one of claims 1 to 6, **characterized by** the fact that each waveguide channel (mux1 to muxp) of the wavelength separator filter (MUX) is formed of four rectilinear light guide sections (g1mux to g4mux) associated with three mirrors (M1, M3).

8. A device according to any one of claims 1 to 6, **characterized by** the fact that each waveguide channel (mux1 to muxp) of the wavelength separator filter (MUX) comprises five rectilinear light guide sections (g1mux to g5mux) associated with four mirrors (M1, M4).

9. A device according to any one of claims 1 to 8, **characterized by** the fact that each mode adapter (T) is formed by an hourglass-shaped etching.

10. A device of claim 9, **characterized by** the fact that each hourglass-shaped mode adapter comprises a broad-mode input portion, a zone of tapering width to push the mode downwards, and a zone of flaring width which enables the broad mode to be transferred to a narrow mode, or vice versa.

11. A device according to claim 9 or claim 10, **characterized by** the fact that each hourglass-shaped mode adapter (T) comprises a throat of non-zero width.

12. A device according to any one of claims 9 to 11, **characterized by** the fact that each mode adapter comprises thin layers (1 and 3) in order to dilute the mode.

13. A device according to any one of claims 1 to 12, **characterized by** the fact that it is fabricated by etchings in a structure deposited by means of a single epitaxial process and comprising first layers (1 to 4) constituting a diluted-structure broad-mode waveguide, second layers (5 and 6) forming a single heterostructure waveguide allowing a transition from broad mode to narrow mode and vice versa, and third layers (7 to 9) allowing both amplification and detection by reverse electrical bias.

14. A device according to any one of claims 1 to 13, **characterized by** the fact that it comprises an n-doped layer above a guide structure, in order to make contact with the photodetector (D) and with the optical amplifier (AO).

15. A device according to any one of claims 1 to 14, **characterized by** the fact that the optical amplifier (AO) is fabricated from two superposed layers of semiconductive material, with a strip being fabricated by etching in the upper layer.

16. A device according to any one of claims 1 to 15, **characterized by** the fact that the photodetector (D) is constituted by a first stack of semiconductive layers constituting a first diode, and a second stack identical to the first stack and placed alongside it, the second stack constituting a second diode, and bias means connected to the first diode through the second diode, the two diodes thus being mounted head to tail, one being reverse biased and the other forward biased.

17. A device according to any one of claims 1 to 16, **characterized by** the fact that the waveguide channels of the wavelength separator filter (MUX) have different refractive indices.

18. A device according to any one of claims 1 to 13 and 17, except when any one of claims 5 to 17 is dependent on claim 2, **characterized by** the fact that another mode adapter (T) is placed in the optical circuit upstream of the detector (D) to facilitate mode transfers.

## Patentansprüche

1. Optoelektronische Vorrichtung zum Trennen von unterschiedlichen Wellenlängen eines zusammengesetzten Eingangssignals und zur Erfassung wenigstens einer der getrennten Wellenlängen, mit:
wenigstens einem Filter (MUX), das in der Lage ist, unterschiedliche Wellenlängen des Signals zu trennen,
wenigstens einem Photodetektor (D), der hinter dem Trennfilter angeordnet ist,
wenigstens einem Modenadapter (T), der vor dem Trennfilter oder zwischen dem Trennfilter und dem Photodetektor angeordnet ist, und
wenigstens einem Wellenleiter (G), der die Verbindung zwischen den erwähnten Elementen sicherstellt,
**dadurch gekennzeichnet, dass** sie ferner wenigstens einen optischen Verstärker (AO) umfasst, dass der Wellenleiter (G) ein Breitmodenleiter ist, dass der Modenadapter (T) unmittelbar vor dem optischen Verstärker angeordnet und angepasst ist, um die breite Mode eines eingangsseitig an ihn angeschlossenen Wellenleiterelements (G1; G3) in eine mit dem optischen Verstärker kompatible schmale Mode umzuwandeln, und dass das Wellenlängentrennfilter (MUX) zwei Diopter (DP1, DP2) und eine Serie von Leiterkanälen (mux1 bis muxp) umfasst, die sich zwischen den Dioptern (DP1, DP2) erstrecken, um optische Wege von unterschiedlichen Längen zu definieren, wobei jeder Leiterkanal eine Mehrzahl von geradlinigen Leiterabschnitten (g1mux bis g4mux) mit unterschiedlichen Neigungen umfasst, die aneinander über jeweilige Umlenkspiegel (M1 bis M4) gekoppelt sind, wobei alle genannten Elemente durch Abscheiden in einer einzigen Epitaxie auf einem halbisolierenden Substrat (SI) integriert sind.

2. Vorrichtung nach Anspruch 1, **dadurch gekennzeichnet, dass** sie wenigstens einen Eingangskanal, der vor dem Trennfilter (MUX) angeordnet ist und den Modenadapter (T), den optischen Verstärker (AO) und das vor dem Modenadapter angeschlossene breitmodige Leiterelement (G1) sowie einen unmittelbar vor dem optischen Verstärker angeordneten zweiten Modenadapter (T) und ein zweites breitmodiges Leiterelement (G2) umfasst, das den zweiten Modenadapter mit dem Trennfilter verbindet, sowie wenigstens einen Ausgangskanal umfasst, der hinter dem Trennfilter (MUX) angeordnet ist und ein drittes Leiterelement (G3) umfasst, das dieses Filter mit einem dritten Modenadapter (T) verbindet, der unmittelbar vor dem Photodetektor (D) angeordnet ist.

3. Vorrichtung nach Anspruch 1, **dadurch gekennzeichnet, dass** der Modenadapter (T) und der optische Verstärker (AO) hinter dem Wellenlängentrennfilter (MUX) und vor dem Photodetektor (D) angeordnet sind.

4. Vorrichtung nach einem der Ansprüche 1 oder 3, **dadurch gekennzeichnet, dass** sie einen vor dem Trennfilter (MUX) angeordneten Eingangskanal, der ein mit diesem Filter verbundenes optisches Leiterelement (G1) umfasst, und wenigstens einen Ausgangskanal umfasst, der hinter dem Trennfilter (MUX) angeordnet ist und das breitmodige Führungselement (G3) umfasst, das vor der Anordnung von Modenadapter (T) und optischem Verstärker (AO) angeschlossen ist, auf die der Photodetektor (D) folgt.

5. Vorrichtung nach einem der Ansprüche 1 bis 4, **dadurch gekennzeichnet, dass** das Wellenlängentrennfilter (MUX) aus einem einzigen binären Material gebildet ist, das dünne Schichten aus quaternärem Material enthält.

6. Vorrichtung nach Anspruch 5, **dadurch gekennzeichnet, dass** das Wellenlängentrennfilter (MUX) aus einer Struktur auf Grundlage von InP gebildet ist, die dünne Schichten aus GaInAsP enthält.

7. Vorrichtung nach einem der Ansprüche 1 bis 6, **dadurch gekennzeichnet, dass** jeder Leiterkanal (mux1 bis muxp) des Wellenlängentrennfilters (MUX) aus vier geradlinigen optischen Leiterabschnitten (g1mux bis g4mux) gebildet ist, denen drei Umlenkspiegel (M1, M3) zugeordnet sind.

8. Vorrichtung nach einem der Ansprüche 1 bis 6, **dadurch gekennzeichnet, dass** jeder Leiterkanal (mux1 bis muxp) des Wellenlängentrennfilters (MUX) fünf geradlinige Wellenleiterabschnitte (g1mux bis g5mux) umfasst, die vier Umlenkspiegeln (M1, M4) zugeordnet sind.

9. Vorrichtung nach Anspruch 8, **dadurch gekennzeichnet, dass** der Modenadapter (T) durch Ätzen in Form einer Sanduhr gebildet ist.

10. Vorrichtung nach Anspruch 9, **dadurch gekennzeichnet, dass** jeder sanduhrförmige Modenadapter einen breitmodigen Eingangsbereich, einen Bereich abnehmender Breite zum Schieben der Mode in die Tiefe und eine Zone zunehmender Breite umfasst, die den Übergang der breiten Mode in eine schmale Mode oder umgekehrt ermöglicht.

11. Vorrichtung nach Anspruch 9 oder 10, **dadurch gekennzeichnet, dass** jeder sanduhrförmige Modenadapter (T) eine Rille von nichtverschindender Breite aufweist.

12. Vorrichtung nach einem der Ansprüche 9 bis 11, **dadurch gekennzeichnet, dass** jeder Modenadapter dünne Schichten (1 und 3) zum Verdünnen der Mode umfasst.

13. Vorrichtung nach einem der Ansprüche 1 bis 12, **dadurch gekennzeichnet, dass** sie durch Ätzen in einer Struktur gebildet ist, die durch eine einzige Epitaxie abgeschieden ist und erste Schichten (1 bis 4), die einen Wellenleiter mit breiter Mode mit verdünnter Struktur bilden, Schichten (5 und 6), die einen einfachen Heterostrukturwellenleiter bilden, der einen Übergang von breiter Mode auf schmale Mode und umgekehrt erlaubt, und Schichten (7 bis 9) umfasst, die gleichzeitig die Verstärkung und die Erfassung durch Umkehr der elektrischen Polarisation ermöglichen.

14. Vorrichtung nach einem der Ansprüche 9 bis 13, **dadurch gekennzeichnet, dass** sie eine n-dotierte Schicht über einer Wellenleiterstruktur umfasst, um den Kontakt des Photodetektors (P) und des optischen Verstärkers (AO) herstellen zu können.

15. Vorrichtung nach einem der Ansprüche 9 bis 14, **dadurch gekennzeichnet, dass** der optische Verstärker (AO) aus zwei übereinanderliegenden Halbleitermaterialschichten und Bildung eines Streifens durch Ätzen in der oberen Schicht gebildet ist.

16. Vorrichtung nach einem der Ansprüche 9 bis 15, **dadurch gekennzeichnet, dass** der Photodetektor (D) gebildet ist durch einen ersten Stapel von Halbleiterschichten, die eine erste Diode bilden, einen mit dem ersten Stapel identischen und neben diesen angeordneten zweiten Stapel, der eine zweite Diode bildet, und mit der ersten Diode über die zweite verbundene Polarisierungsmittel, wobei die zwei Dioden antiparallel montiert sind, so dass eine in Sperrrichtung und die andere in Durchgangsrichtung polarisiert ist.

17. Vorrichtung nach einem der Ansprüche 9 bis 16, **dadurch gekennzeichnet, dass** die Leiterkanäle des Wellenlängentrennfilters (MUX) unterschiedliche Indizes aufweisen.

18. Vorrichtung nach einem der Ansprüche 1 und 3 bis 17, mit Ausnahme eines der Ansprüche 5 bis 17, wenn er auf Anspruch 2 rückbezogen ist, **dadurch gekennzeichnet, dass** ein anderer Modenadapter (T) in dem optischen Kreis vor dem Detektor (D) angeordnet ist, um die Modenübergänge zu erleichtern.
